# FASCICULE DE BREVET EUROPEEN

(11) **EP 3 089 864 B1**
(45) Date de publication et mention de la délivrance du brevet: **23.09.2020**
(21) Numéro de dépôt: 14833517.7
(22) Date de dépôt: 22.12.2014
(51) Int. Cl.: B29C 70/88, B29C 70/08, H05K 9/00, B29L 31/00, B29L 31/30

(54) **SEMI-PRODUIT EN MATIÈRE COMPOSITE COMPRENANT UN FILM SOUPLE DE BLINDAGE ÉLECTROMAGNÉTIQUE**
HALBZEUG AUS EINEM VERBUNDMATERIAL MIT EINEM FLEXIBLEN ELEKTROMAGNETISCHEN ABSCHIRMUNGSFILM
SEMI-FINISHED PRODUCT MADE FROM COMPOSITE MATERIAL, COMPRISING A FLEXIBLE ELECTROMAGNETIC SHIELDING FILM

(30) Priorité: 30.12.2013 FR 1363671
(43) Date de publication de la demande: 09.11.2016
(73) Titulaire: Compagnie Plastic Omnium, 69007 Lyon (FR)
(72) Inventeur: ANDRE, Gerald, 01500 Amberieu En Bugey (FR); CHERON, Hugues, 01800 Meximieux (FR)
(74) Mandataire: Remy, Vincent Noel Paul
(86) Numéro de dépôt international: PCT/FR2014/053512
(87) Numéro de publication internationale: WO 2015/101739

(56) Documents cités:
- EP-A1- 1 099 541
- EP-A1- 2 647 486
- US-A- 4 678 699
- US-A1- 2010 239 798

## Description

La présente invention concerne le domaine technique des produits en matière plastique.

En particulier l'invention concerne un matériau (semi-produit) composite ayant une propriété de blindage électromagnétique destiné à fabriquer un caisson pour encapsuler des systèmes électriques, tels que des batteries, embarqués sur des véhicules.

Pour encapsuler un ensemble de batteries pour véhicules hybrides ou électriques, la solution souvent retenue aujourd'hui est un caisson entièrement en métal, notamment en aluminium. Le choix de ce métal est justifié pour sa tenue mécanique et les propriétés de blindage électromagnétique qui sont indispensables pour confiner les champs importants générés par les batteries et les autres composants électriques.

Cependant, les caissons en métal augmentent le poids du véhicule dans lesquels ils sont installés et ne présentent pas d'isolation électrique vers l'extérieur. De plus, ils peuvent présenter un danger potentiel vis-à-vis des utilisateurs. Enfin, les caissons en métal ne possèdent qu'une faible isolation thermique, incompatible avec le maintien et le contrôle des températures internes des batteries vis-à-vis des variations externes.

Pour remédier à ce problème de poids, il est connu d'utiliser des caissons réalisés au moins pour partie en matériaux polymères ou composites, du type comportant une résine thermoplastique ou thermodurcissable et des fibres de renfort.

Pour donner à ces caissons réalisés en partie en matériaux composites une propriété de blindage électromagnétique, il est par ailleurs connu les procédés suivants :
- la métallisation par peinture conductrice : cette solution ne s'avère pas suffisamment efficaces dans les gammes de fréquence et de puissance concernées par les systèmes batteries embarqués sur des véhicules ;
- le surmoulage de grilles métalliques, de toiles métalliques ou de métal déployé : ce procédé présente l'avantage d'être intégrable dans un procédé de moulage. En effet, les couches métalliques supportent d'être étirées pour épouser les formes de la pièce. Cependant, cette solution s'avère également insuffisante en efficacité de blindage, même si l'on peut augmenter les épaisseurs et ainsi être relativement efficace dans les basses fréquences, essentiellement à cause des ouvertures et des discontinuités entre les mailles pour les toiles ;
- le traitement de surface par métallisation, par exemple par projection de métal en fusion ou par dépôt électrolytique de Zn, Cu ou d'Al : ce procédé semble être efficace. Cependant, ce procédé peut nécessiter de fortes épaisseurs de dépôt. Ceci pose des problèmes conséquents au niveau des procédés de transformation, des temps de cycle et des moyens industriels à déployer afin de tenir des cadences automobiles ;
- l'utilisation de métaux particuliers, dit « mu métaux », aux propriétés magnétiques importantes, obtenues généralement par des matières ferreuses avec de fortes teneurs en Nickel. Ces métaux sont réputés pour agir très efficacement sur les champs électromagnétiques de basses fréquences. Cette solution est la plus adaptée au véhicule. Cependant elle présente des effets de saturation en fonction de la puissance du champ magnétique, notamment à plus haute fréquence, et elle doit ainsi, là encore, être mise en oeuvre en forte épaisseur pour compenser ce phénomène, ce qui pose très vite des problèmes de masse car ces matières présentent une densité supérieure à l'acier.
- Par ailleurs, il est connu dans la littérature scientifique, l'avantage d'un effet multicouche : le blindage étant très efficace sur les surfaces des écrans plutôt qu'à cœur.

Les documents US 4 678 699 et EP 2 647 486 décrivent un semi-produit selon le préambule de la revendication 1.

L'invention a pour but de remédier à ces inconvénients en fournissant un semi-produit permettant de réaliser un caisson adapté au besoin des véhicules en termes de forme et d'exploitation des volumes, tout en garantissant un comportement de blindage électromagnétique. Pour ce faire le semi-produit selon l'invention comporte une matrice thermoplastique ou thermodurcissable et des charges de renfort, ainsi qu'au moins un film de blindage électromagnétique positionné dans l'épaisseur du semi-produit, le film de blindage électromagnétique comportant des orifices.

Le semi-produit selon l'invention permet un gain de masse pour l'ensemble de la solution (caisson complet encapsulant les batteries d'un véhicule et intégrant le blindage), par rapport à des solutions métalliques ou composite avec projection métallique.

De plus, le procédé de fabrication d'un caisson peut être réalisé en flux continu et en grandes cadences.

De préférence, la surface totale des orifices est très inférieure à la surface de la matière formant le film de blindage électromagnétique.

Selon l'invention, le film de blindage électromagnétique peut être perforé à intervalle régulier, et il peut ne pas être plan.

De préférence, le film de blindage électromagnétique est un film métallique souple, ou un film métallisé. Le film de blindage électromagnétique peut par exemple être un film en aluminium.

Selon un mode de réalisation, le film de blindage électromagnétique est positionné en surface du semi-produit.

Le semi-produit peut être sous forme d'une feuille, et le film de blindage électromagnétique peut être noyé dans l'épaisseur de la feuille. Mais, le film de blindage électromagnétique peut également être intercalé entre deux feuilles de matière composite, formant une âme souple.

Le semi-produit peut contenir au moins une couche comportant deux films de blindage électromagnétique séparés par un milieu isolant électriquement.

Le semi-produit peut comporter plusieurs bandes de films de blindage électromagnétique, les bandes ayant un recouvrement non nul. Les bandes peuvent être enduites de résine et/ou d'un produit compatible chimiquement avec une résine de la matrice thermoplastique ou thermodurcissable.

L'invention concerne également un caisson d'hébergement d'équipement embarqué de stockage et/ou de transmission de puissance électrique d'entrainement de véhicule automobile, le caisson décrivant une surface enfermant complètement un logement de réception d'un tel équipement. Ce caisson est réalisé avec le semi-produit selon l'invention.

L'invention concerne également un procédé de fabrication d'une pièce par moulage, dans lequel on utilise plusieurs bandes du semi-produit selon l'invention, et l'on agence les bandes de façon à ce qu'après moulage, l'intégralité de la pièce selon une direction normale aux surfaces de la pièce, soit recouverte d'au moins une épaisseur de film de blindage électromagnétique.

Selon l'invention, la pièce peut être un caisson d'hébergement d'équipement embarqué de stockage et/ou de transmission de puissance électrique d'entrainement de véhicule automobile, et on réalise les étapes suivantes au moyen d'un moule de type poinçon-matrice :
- on dispose sur l'une des parois du moule plusieurs bandes du semi-produit (SP) selon l'une des revendications 1 à 12, de façon à ce que l'intégralité de la surface du caisson soit couverte par le film de blindage électromagnétique (FBE) après ouverture du moule ;
- on ferme le moule, et on applique une pression et une température choisies pour permettre un fluage et une polymérisation de la matrice thermoplastique ou thermodurcissable, de sorte que la matrice assure une cohésion en passant à travers les orifices (ORI) du film de blindage électromagnétique (FBE) ; et
- on démoule le caisson ainsi obtenue.

L'intégralité de la surface du caisson peut être couverte par le film de blindage électromagnétique après ouverture du moule, par des bandes du semi produit discontinues et se chevauchant entre elles.

Enfin, le chevauchement entre chaque bande est de préférence de 30 à 40mm minimum.

L'invention sera mieux comprise à la lecture des figures annexées, qui sont fournies à titre d'exemples et ne présentent aucun caractère limitatif, dans lesquelles :
La figure 1 représente un mode de réalisation du semi-produit selon l'invention.
La figure 2 illustre l'utilisation d'un milieu isolant électriquement intercalé entre deux films de blindage.
La figure 3 illustre un film de blindage gaufré et son utilisation lors du moulage.
La figure 4 illustre le procédé d'agencement de bande de semi-produit pour former un produit fini sans fuite électromagnétique.

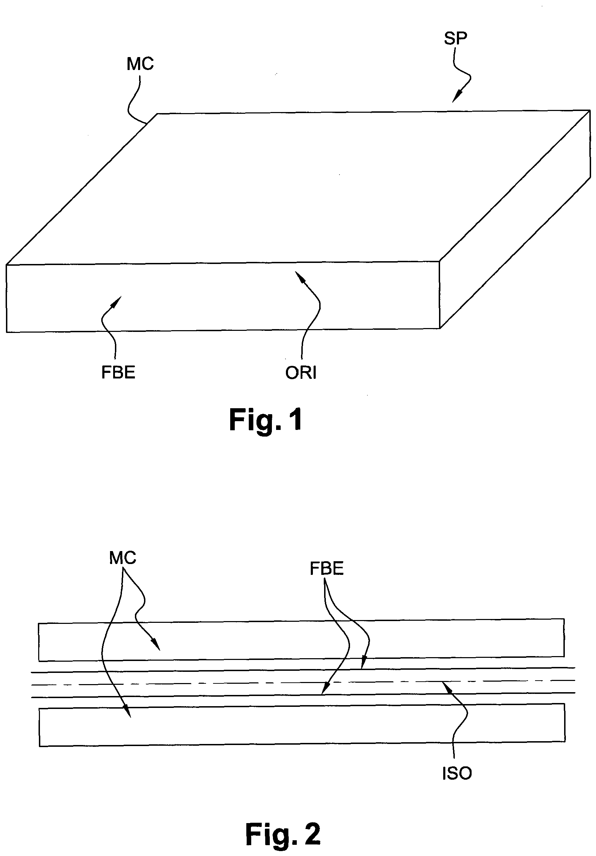

L'invention concerne un semi produit (SP), illustré sur la figure 1, et comportant :
- Une matière composite (MC) comprenant :
   ∘ une matrice thermoplastique ou thermodurcissable (PP, PA, UP ou VE) ;
   ∘ des charges de renfort fibreuses (verre, fibres naturelles, carbone..) ; et/ou
   ∘ des charges de renfort en poudre telles que carbonate de calcium.
- Au moins un film de blindage électromagnétique(FBE) positionné dans l'épaisseur du semi-produit, et comportant en ensemble d'orifices (ORI).

Les orifices (ORI) du film de blindage électromagnétique (FBE) permettent d'assurer une cohésion entre la matière composite (MC) et le film de blindage (FBE). En effet, lors du moulage d'une pièce à partir d'un semi-produit (SP) selon l'invention, la matière flue (FLU) à travers les orifices (ORI) avant de durcir.

La taille des orifices (ORI) est minimisée pour garantir le blindage électromagnétique. Mais un compromis peut être déterminé pour minimiser encore le poids de la pièce finie réalisée à partir du semi-produit.

A la différence d'une grille, la surface totale des orifices (ORI) est très inférieure à la surface de la matière du film de blindage.

De préférence, le film de blindage électromagnétique (FBE) est perforé à intervalle régulier, de façon à fournir une cohésion homogène.

Le film de blindage électromagnétique (FBE) peut être un film métallique. De préférence, le film est souple, de façon à n'assurer qu'une fonction de blindage électromagnétique tout en limitant le poids de la pièce finie, et non une fonction de renfort du semi-produit.

Le film de blindage (FBE) est de préférence réalisé en aluminium. Il a une épaisseur de préférence comprise entre 0,1 et 0,5mm.

Le film de blindage électromagnétique (FBE) peut également être un film métallisé réalisé à partir d'un substrat compatible avec les matières composites mise en œuvre.

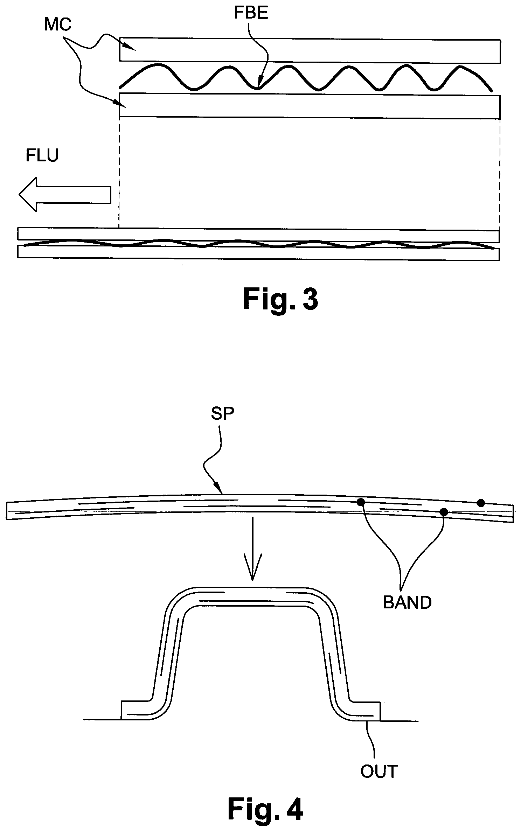

Selon l'invention, le film de blindage électromagnétique (FBE) n'est pas plan, mais possède des plis. Par exemple et comme illustré sur la figure 3, un film peut avoir une forme de gaufrage, sous forme de pyramides circulaires concentriques par exemple. Cette configuration permet d'accompagner le fluage (FLU) de la matière composite lors du moulage comme l'illustre la figure 3, car le film se « déplie ». Ceci permet entre autre d'éviter le déchirement du film.

De préférence, le semi-produit (SP) selon l'invention est préparé sous forme de plaque (éventuellement en rouleau), comportant une ou plusieurs feuilles de matière composite.

Selon un premier mode de réalisation, le film de blindage (FBE) est noyé dans l'épaisseur d'une feuille de matière composite.

Selon un second mode de réalisation, le semi-produit en matière composite intégrant un film de blindage comporte :
- Une première feuille de matière composite ;
- Une seconde feuille de matière composite ;
- Un film métallique ou métallisé souple intercalé entre les deux feuilles de matière composite, et formant une âme souple, et perforé à intervalle régulier.

L'avantage de ces deux modes de réalisation et de fournir une protection au film de blindage contre les agressions ou la corrosion. De plus, le système de blindage obtenu n'est pas conducteur en surface de la pièce. On écarte ainsi des risques de contact avec des éléments sous tension.

Cependant, selon une variante, le film de blindage (FBE) est positionné en surface d'une feuille en matière composite.

Selon un mode de réalisation, le semi-produit (SP) selon l'invention comporte plusieurs films de blindage (FBE). Ces films peuvent avoir des compositions et/ou des épaisseurs et/ou des formes différentes.

Selon un autre mode de réalisation (figure 2), le semi-produit (SP) inclut au moins une couche comportant deux films de blindage électromagnétique (FBE) selon l'invention séparés par un milieu isolant (ISO) électriquement (constitué de polymère par exemple) comme l'illustre la figure 2. Le semi-produit (SP) selon l'invention peut comporter une ou plusieurs de ces couches, en combinaison ou non avec d'autres films de blindage (FBE). Le milieu isolant (ISO) peut lui aussi être perforé de la même façon que les films de blindage électromagnétique (FBE).

**L'invention concerne également un caisson** d'hébergement d'équipement embarqué de stockage et/ou de transmission de puissance électrique d'entrainement de véhicule automobile. Le caisson décrit une surface enfermant complètement un logement de réception d'un tel équipement. Le caisson est réalisé avec le semi-produit (SP) selon l'invention.

**L'invention concerne également un procédé de fabrication d'un caisson** pour encapsuler des systèmes de batteries embarqués sur des véhicules.

Pour mouler une pièce, telle qu'un caisson, à partir du semi-produit selon l'invention, on utilise une à plusieurs bandes de semi-produit que l'on agence de façon à ce qu'après moulage l'intégralité de la pièce, selon une direction normale aux surfaces de la pièce, soit recouverte d'au moins une épaisseur de film de blindage électromagnétique (FBE). Ainsi, la pièce ne comporte aucune rupture du film de blindage, ceci afin d'éviter toute fuite de champs électromagnétique.

Avantageusement, le semi-produit peut déjà comporter plusieurs bandes (BAND) de film de blindage électromagnétique (FBE) avec un recouvrement non nul, afin de faciliter cette opération d'habillage de la forme de l'outil (OUT). Cette configuration est illustrée sur la figure 4. Cet outil (OUT) est soit un moule pouvant transformer sous pression la pièce soit une forme permettant de réaliser une préforme avec le semi produit avant de le charger dans un moule. Avantageusement, lors de la fabrication du semi-produit, les bandes sont enduites de résine ou d'un produit compatible chimiquement avec la résine employée, afin de faciliter leur glissement lors du procédé de transformation de la pièce, et de faciliter la cohésion dans l'épaisseur de la pièce.

Selon un exemple, pour réaliser la pièce (caisson) selon l'invention, on utilise un moule de type matrice-poinçon par exemple, et on réalise les étapes suivantes :
- on dispose sur la paroi du poinçon du moule plusieurs bandes du semi-produit (SP) selon l'invention, de façon à ce que l'intégralité de la surface du caisson soit couverte par le film de blindage électromagnétique après ouverture du moule, et que l'intégralité de la forme, selon une direction normale aux surfaces de la pièce, soit recouverte d'au moins une épaisseur de film de blindage. On positionne ces bandes en formant des chevauchements entre elles. Les chevauchements sont dimensionnés et positionnés pour qu'après la fermeture de la partie matrice, les bandes glissent afin de former la pièce et que l'intégralité de la surface de la pièce soit couverte par le film de blindage électromagnétique par bandes discontinues. Selon un exemple, le chevauchement entre chaque bande est de 30 à 40mm minimum.
- on ferme le moule, et on applique une pression et une température choisies pour permettre un fluage et une polymérisation de la matrice thermoplastique ou thermodurcissable. Il est possible d'appliquer une basse pression (inférieure à 20 bar), mais avantageusement on applique une haute pression (supérieure à 80bar) de tel sorte que la matière composite flue dans l'empreinte et assure une cohésion en passant à travers les orifices du film de blindage électromagnétique.
- on démoule la pièce ainsi obtenue.

Selon un mode de réalisation, afin de garantir la présence du film en bord pièce, l'empreinte du moule est prévue plus grande que la pièce finie. On complète alors la fabrication par une opération de recoupe de la pièce sortie du moule.

## Revendications

1. Semi-Produit (SP) en matière composite (MC) comprenant une matrice thermoplastique ou thermodurcissable et des charges de renfort, au moins un film de blindage électromagnétique(FBE) positionné dans l'épaisseur du semi-produit (SP), le film de blindage électromagnétique (FBE) comportant des orifices (ORI), **caractérisé en ce que** le semi-produit comprend plusieurs bandes (BAND) de films de blindage électromagnétique (FBE), les bandes ayant un recouvrement non nul, le film de blindage électromagnétique (FBE) n'étant pas plan.

2. Semi-Produit selon la revendication 1, dans lequel la surface totale des orifices (ORI) est très inférieure à la surface de la matière formant le film de blindage électromagnétique (FBE).

3. Semi-Produit selon l'une des revendications précédentes, dans lequel le film de blindage électromagnétique (FBE) est perforé à intervalle régulier.

4. Semi-Produit selon l'une des revendications précédentes, dans lequel le film de blindage électromagnétique (FBE) est un film métallique souple, ou un film métallisé.

5. Semi-Produit selon la revendication 4, dans lequel le film de blindage électromagnétique (FBE) est un film en aluminium.

6. Semi-Produit selon l'une des revendications précédentes, dans lequel le film de blindage électromagnétique (FBE) est positionné en surface du semi-produit.

7. Semi-Produit selon l'une des revendications 1 à 5, dans lequel le semi-produit (SP) est sous forme d'une feuille, et le film de blindage électromagnétique (FBE) est noyé dans l'épaisseur de la feuille.

8. Semi-Produit selon l'une des revendications 1 à 5, dans lequel le film de blindage électromagnétique (FBE) est intercalé entre deux feuilles de matière composite (MC), formant une âme souple.

9. Semi-Produit selon l'une des revendications précédentes, contenant au moins une couche comportant deux films de blindage électromagnétique (FBE) séparés par un milieu isolant électriquement (ISO).

10. Semi-Produit selon l'une des revendications précédentes, dans lequel les bandes (BAND) sont enduites de résine et/ou d'un produit compatible chimiquement avec une résine de la matrice thermoplastique ou thermodurcissable.

11. Caisson d'hébergement d'équipement embarqué de stockage et/ou de transmission de puissance électrique d'entrainement de véhicule automobile, le caisson décrivant une surface enfermant complètement un logement de réception d'un tel équipement, **caractérisé en ce que** le caisson est réalisé avec le semi-produit (SP) selon l'une des revendications précédentes.

12. Procédé de fabrication d'une pièce par moulage, **caractérisé en ce que** l'on utilise plusieurs bandes du semi-produit (SP) selon l'une des revendications 1 à 10, et l'on dispose sur l'une des parois du moule plusieurs bandes du semi-produit (SP) de façon à ce qu'après moulage, l'intégralité de la pièce selon une direction normale aux surfaces de la pièce, soit recouverte d'au moins une épaisseur de film de blindage électromagnétique (FBE).

13. Procédé selon la revendication 12, dans lequel la pièce est un caisson d'hébergement d'équipement embarqué de stockage et/ou de transmission de puissance électrique d'entrainement de véhicule automobile, et on réalise les étapes suivantes au moyen d'un moule de type poinçon-matrice :
- on dispose sur l'une des parois du moule plusieurs bandes du semi-produit (SP) selon l'une des revendications 1 à 11, de façon à ce que l'intégralité de la surface du caisson soit couverte par le film de blindage électromagnétique (FBE) après ouverture du moule ;
- on ferme le moule, et on applique une pression et une température choisies pour permettre un fluage et une polymérisation de la matrice thermoplastique ou thermodurcissable, de sorte que la matrice assure une cohésion en passant à travers les orifices (ORI) du film de blindage électromagnétique (FBE) ; et
- on démoule le caisson ainsi obtenue.

14. Procédé selon la revendication 13, dans lequel l'intégralité de la surface du caisson est couverte par le film de blindage électromagnétique (FBE) après ouverture du moule, par des bandes du semi produit discontinues et se chevauchant entre elles.

15. Procédé selon la revendication 14, dans lequel le chevauchement entre chaque bande est de 30 à 40mm minimum.

## Patentansprüche

1. Halbzeug (SP) aus Verbundmaterial (MC), umfassend eine thermoplastische oder duroplastische Matrix und Verstärkungsfüllstoffe, wenigstens einen Film zur elektromagnetischen Abschirmung (FBE), der in der Dicke des Halbzeugs (SP) positioniert ist, wobei der Film zur elektromagnetischen Abschirmung (FBE) Öffnungen (ORI) aufweist, **dadurch gekennzeichnet, dass** das Halbzeug mehrere Bahnen (BAND) aus Filmen zur elektromagnetischen Abschirmung (FBE) umfasst, wobei die Bahnen eine Überdeckung ungleich null aufweisen, wobei der Film zur elektromagnetischen Abschirmung (FBE) nicht flächig ist.

2. Halbzeug nach Anspruch 1 wobei die Gesamtoberfläche der Öffnungen (ORI) viel kleiner als die Oberfläche des Materials ist, das den Film zur elektromagnetischen Abschirmung (FBE) bildet.

3. Halbzeug nach einem der vorhergehenden Ansprüche, wobei der Film zur elektromagnetischen Abschirmung (FBE) in regelmäßigen Abständen perforiert ist.

4. Halbzeug nach einem der vorhergehenden Ansprüche, wobei der Film zur elektromagnetischen Abschirmung (FBE) ein flexibler metallischer Film oder ein metallisierter Film ist.

5. Halbzeug nach Anspruch 4 wobei der Film zur elektromagnetischen Abschirmung (FBE) ein Film aus Aluminium ist.

6. Halbzeug nach einem der vorhergehenden Ansprüche, wobei der Film zur elektromagnetischen Abschirmung (FBE) an der Oberfläche des Halbzeugs positioniert ist.

7. Halbzeug nach einem der Ansprüche 1 bis 5, wobei das Halbzeug (SP) die Form einer Folie aufweist und der Film zur elektromagnetischen Abschirmung (FBE) in der Dicke der Folie eingebettet ist.

8. Halbzeug nach einem der Ansprüche 1 bis 5, wobei der Film zur elektromagnetischen Abschirmung (FBE) zwischen zwei Folien aus Verbundmaterial (MC) angeordnet ist und einen flexiblen Kern bildet.

9. Halbzeug nach einem der vorhergehenden Ansprüche, umfassend wenigstens eine Schicht, die zwei Filme zur elektromagnetischen Abschirmung (FBE) aufweist, die durch ein elektrisch isolierendes Medium (ISO) getrennt sind.

10. Halbzeug nach einem der vorhergehenden Ansprüche, wobei die Bahnen (BAND) mit Harz und/oder einem Stoff überzogen sind, der mit einem Harz der thermoplastischen oder duroplastischen Matrix chemisch kompatibel ist.

11. Gehäuse zur Aufnahme eines an Bord eingebauten Geräts zum Speichern und/oder zum Übertragen von elektrischer Leistung zum Antreiben eines Kraftfahrzeugs, wobei das Gehäuse eine Oberfläche beschreibt, die eine Aufnahme für ein derartiges Gerät vollständig einschließt, **dadurch gekennzeichnet, dass** das Gehäuse mit dem Halbzeug (SP) nach einem der vorhergehenden Ansprüche realisiert ist.

12. Verfahren zur Herstellung eines Teils durch Formen, **dadurch gekennzeichnet, dass** mehrere Bahnen des Halbzeugs (SP) nach einem der Ansprüche 1 bis 10 verwendet werden und auf einer der Wände des Formwerkzeugs mehrere Bahnen des Halbzeugs (SP) in der Form angeordnet werden, dass, nach dem Formen, das gesamte Teil gemäß einer Richtung senkrecht zu den Oberflächen des Teils mit wenigstens einer Dicke des Films zur elektromagnetischen Abschirmung (FBE) beschichtet ist.

13. Verfahren nach Anspruch 12, bei dem das Teil ein Gehäuse zur Aufnahme eines an Bord eingebauten Geräts zum Speichern und/oder zum Übertragen von elektrischer Leistung zum Antreiben eines Kraftfahrzeugs ist und die folgenden Schritte mittels eines Formwerkzeugs vom Stempel-Matrizen-Typ durchgeführt werden:
- Anordnen auf einer der Wände des Formwerkzeugs von mehreren Bahnen des Halbzeugs (SP) nach einem der Ansprüche 1 bis 11 in der Form, dass nach Öffnen des Formwerkzeugs die gesamte Oberfläche des Gehäuses mit dem Film zur elektromagnetischen Abschirmung (FBE) beschichtet ist;
- Schließen des Formwerkzeugs und
- Beaufschlagen mit einem Druck und einer Temperatur, die so gewählt sind, dass sie ein Fließen und eine Polymerisierung der thermoplastischen oder duroplastischen Matrix gestatten, so dass die Matrix eine Kohäsion bewirkt, indem sie durch die Öffnungen (ORI) des Films zur elektromagnetischen Abschirmung (FBE) fließt; und
- Entformen des so erhaltenen Gehäuses.

14. Verfahren nach Anspruch 13, bei dem nach Öffnen des Formwerkzeugs die gesamte Oberfläche des Gehäuses mit dem Film zur elektromagnetischen Abschirmung (FBE) beschichtet ist, mit Bahnen des Halbzeugs, die unterbrochen sind und sich überlappen.

15. Verfahren nach Anspruch 14, bei dem die Überlappung zwischen jeder Bahn mindestens 30 bis 40 mm beträgt.

## Claims

1. Semi-finished product (SP) made from composite material (MC), comprising a thermoplastic or thermosetting matrix and reinforcement fillers, at least one electromagnetic shielding film (FBE) positioned in the thickness of the semi-finished product (SP), the electromagnetic shielding film (FBE) comprising holes (ORI), **characterised in that** the semi-finished product comprises several strips (BAND) of electromagnetic shielding films (FBE), the strips having a non-zero overlap, the electromagnetic shielding film (FBE) not being flat.

2. Semi-finished product according to claim 1, wherein the total area of the holes (ORI) is much less than the area of the material forming the electromagnetic shielding film (FBE).

3. Semi-finished product according to one of the preceding claims, wherein the electromagnetic shielding film (FBE) is perforated at regular intervals.

4. Semi-finished product according to one of the preceding claims, wherein the electromagnetic shielding film (FBE) is a flexible metallic film, or a metallised film.

5. Semi-finished product according to claim 4, wherein the electromagnetic shielding film (FBE) is an aluminium film.

6. Semi-finished product according to one of the preceding claims, wherein the electromagnetic shielding film (FBE) is positioned on the surface of the semi-finished product.

7. Semi-finished product according to one of claims 1 to 5, wherein the semi-finished product (SP) consists of a sheet, and the electromagnetic shielding film (FBE) is embedded in the thickness of the sheet.

8. Semi-finished product according to one of claims 1 to 5, wherein the electromagnetic shielding film (FBE) is inserted between two sheets of composite material (MC), forming a flexible core.

9. Semi-finished product according to one of the preceding claims, containing at least one layer comprising two electromagnetic shielding films (FBE) separated by an electrically insulating medium (ISO).

10. Semi-finished product according to one of the preceding claims, wherein the strips (BAND) are coated with resin and/or a product chemically compatible with a resin of the thermoplastic or thermosetting matrix.

11. Box for accommodating onboard equipment for the storage and/or transmission of electric power for driving a motor vehicle, the box describing a surface completely enclosing a housing for receiving such equipment, **characterised in that** the box is made with the semi-finished product (SP) according to one of the preceding claims.

12. Method for manufacturing a part by moulding, **characterised in that** several strips of the semi-finished product (SP) according to one of claims 1 to 10 are used, and several strips of the semi-finished product (SP) are arranged on one of the mould walls so that after moulding, the entire part in a direction normal to the surfaces of the part is covered with at least one thickness of electromagnetic shielding film (FBE).

13. Method according to claim 12, wherein the part is a box for accommodating onboard equipment for the storage and/or transmission of electric power for driving a motor vehicle, and the following steps are performed using a punchdie type mould:
- arranging several strips of the semi-finished product (SP) according to one of claims 1 to 11 on one of the mould walls, so that the entire surface of the box is covered by the electromagnetic shielding film (FBE) after opening the mould;
- closing the mould, and applying pressure and temperature chosen to enable the thermoplastic or thermosetting matrix to flow and polymerise, so that the matrix provides cohesion by going through the holes (ORI) of the electromagnetic shielding film (FBE);
- and removing the box thus obtained from the mould.

14. Method according to claim 13, wherein the entire surface of the box is covered by the electromagnetic shielding film (FBE) after opening the mould, by discontinuous overlapping strips of the semi-finished product.

15. Method according to claim 14, wherein the overlap between each strip is at least 30 mm to 40 mm.
